(19) Europäisches Patentamt

European Patent Office

Office européen des brevets

(11) **EP 4 696 539 A1**

(12) **EUROPEAN PATENT APPLICATION**

(43) Date of publication:
**18.02.2026 Bulletin 2026/08**

(21) Application number: **24194073.3**

(22) Date of filing: **12.08.2024**

(51) International Patent Classification (IPC):
**B60L 3/12** (2006.01)    **B60L 50/75** (2019.01)
**B60L 58/40** (2019.01)    **B60L 58/30** (2019.01)

(52) Cooperative Patent Classification (CPC):
**B60L 58/40; B60L 3/12; B60L 50/75; B60L 58/12; B60L 58/13; B60L 58/30; B60L 58/32; G01R 31/367; H01M 8/0432; H01M 8/04537; H01M 10/48; H01M 10/486; H01M 16/006;**
B60L 2240/545; B60L 2240/547;    (Cont.)

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**GE KH MA MD TN**

(71) Applicant: **VOLVO TRUCK CORPORATION**
**405 08 Göteborg (SE)**

(72) Inventors:
• **GELSO, Esteban**
  **421 51 VÄSTRA FRÖLUNDA (SE)**
• **RAZAZNEJAD, Behrooz**
  **413 28 GÖTEBORG (SE)**

(74) Representative: **Ström & Gulliksson AB**
  **P.O. Box 4188**
  **203 13 Malmö (SE)**

Remarks:
Amended claims in accordance with Rule 137(2) EPC.

(54) **COMPUTER SYSTEM AND COMPUTER-IMPLEMENTED METHOD FOR CONTROLLING POWER TRANSFER IN A VEHICLE**

(57)    Present disclosure relates to a computer system comprising processing circuitry configured to during use of an energy storage system of a vehicle obtain operational data associated with one or more operational properties of the present operation of the energy storage system, determine a present operating region of the energy storage system based on the operational data, estimate one or more energy storage properties of the energy storage system based on the determined present operating region, and control the power transfer to and/or from the energy storage system based on the estimated one or more energy storage properties.

FIG. 1

EP 4 696 539 A1

(52) Cooperative Patent Classification (CPC): (Cont.)
B60L 2240/549; B60L 2260/44; H01M 2220/20;
H01M 2250/20

# EP 4 696 539 A1

**Description**

**TECHNICAL FIELD**

The disclosure relates generally to computer systems and computer-implemented methods. In particular aspects, the disclosure relates to a computer system and a computer-implemented for controlling power transfer in a vehicle. The disclosure can be applied to heavy-duty vehicles, such as trucks, buses, and construction equipment, among other vehicle types. Although the disclosure may be described with respect to a particular vehicle, the disclosure is not restricted to any particular vehicle.

**BACKGROUND**

A fuel cell electric vehicle, hereinafter abbreviated FCEV, is a vehicle operating by using a fuel cell stack that converts hydrogen into electricity to power an electric motor for propelling the FCEV.

A battery electric vehicle, hereinafter abbreviated BEV, is a vehicle operating by using a battery system with electrochemical cells to power an electric motor for propelling the BEV.

Commonly, vehicles may include more than one power source for powering vehicle auxiliary systems and the propulsion, allowing for the option to select between different power sources. The efficiency of a battery system or a fuel cell system will fluctuate based on a number of factors. In such vehicles it may be desired to prioritize utilization of the battery system or fuel cell system at times when they are efficient and de-prioritize utilization of the battery system or fuel cell system at times when they are inefficient.

Notably, due to the inherent strengths and weaknesses of BEVs and FCEVs, vehicles may combine the two, e.g. utilize both batteries and fuel cells for propelling the vehicle. In such vehicles it may be desired to control the utilization of the energy sources depending on the present and/or future conditions to improve the energy-efficiency of the vehicle.

**SUMMARY**

According to a first aspect of the disclosure, a computer system is provided. The computer system comprises processing circuitry configured to during use of an energy storage system of a vehicle obtain operational data associated with one or more operational properties of the present operation of the energy storage system. The processing circuitry is configured to determine a present operating region of the energy storage system based on the operational data. The processing circuitry is configured to estimate one or more energy storage properties of the energy storage system based on the determined present operating region. The processing circuitry is configured to control the power transfer to and/or from the energy storage system based on the estimated one or more energy storage properties. The first aspect of the disclosure may seek to achieve a more energy-efficient vehicle. A technical benefit may include that the performance of the energy storage system may be monitored and predicted in a more accurate manner, allowing for a more optimized energy efficiency by controlling the usage of the energy storage system based on its present and predicted performance in its present operating region.

Optionally in some examples, including in at least one preferred example, the processing circuitry may be further configured to control the power transfer between the energy storage system and a propulsion source of the vehicle based on the estimated one or more energy storage properties. A technical benefit may include that a more energy-efficient propulsion may be achieved by means of the computer system allowing for the energy storage system to power the propulsion source when the energy storage system is operating in an energy-efficient operating region and when the energy storage system is operating in a less-energy efficient operating region, set the degree of usage to zero or to a lower level.

Optionally in some examples, including in at least one preferred example, the one or more operational properties may comprise a stack current of the energy storage system, a state of charge of the energy storage system, a pressure in the energy storage system and/or a stack temperature of the energy storage system.

Optionally in some examples, including in at least one preferred example, the energy storage system may be a fuel cell system. The one or more energy storage properties may be one or more of a Nernst voltage, ohmic losses and/or activation losses of the fuel cell system. A technical benefit may include that a more energy-efficient fuel cell system may be achieved.

Optionally in some examples, including in at least one preferred example, the energy storage system may be a battery system. The one or more energy storage properties may be one or more of an open-circuit voltage, ohmic losses and/or activation losses of the battery system. A technical benefit may include that a more energy-efficient battery system may be achieved.

Optionally in some examples, including in least one preferred example, the processing circuitry may be further configured to determine the present operating region as a subset of the total operating range of the energy storage system.

Optionally in some examples, including in least one preferred examples, the processing circuitry may be further configured to obtain a stack voltage of the energy storage system. The processing circuitry may be further configured to estimate the one or more energy storage properties of the energy storage system based on the determined present operating region and the stack voltage. A technical benefit may include that the one or more energy storage properties may be estimated in a more accurate manner.

Optionally in some examples, including in least one preferred example, the processing circuitry may be further configured to obtain a DC-DC output current and DC-DC output voltage of the energy storage system, and obtain the stack voltage and stack current based on the DC-DC output current and DC-DC output voltage and a model of a DC-DC converter of the vehicle connected to the energy storage system. A technical benefit may include that the need for sensors arranged in the energy storage system may be alleviated, potentially reducing cost and complexity.

Optionally in some examples, including in least one preferred example, the processing circuitry may be further configured to obtain the stack voltage and the stack current of the energy storage system based on sensor data obtained from an electric voltage sensor and an electric current sensor configured to measure the energy storage voltage and energy storage current associated with the energy storage system, respectively. A technical benefit may include that the one or more energy storage properties may be estimated in a more accurate manner.

Optionally in some examples, the processing circuitry may be further configured to determine a measure of uncertainty for the estimated one or more energy storage properties, and control the power transfer to and/or from the energy storage system based on the measure of uncertainty. A technical benefit may include an improved predictability and accuracy for the control of the energy storage system, since, the computer system may take into account potential inaccuracies in the estimation.

Optionally in some examples, including in at least one preferred example, the processing circuitry may be further configured to estimate the one or more energy storage properties for the determined present operating region based on sliding window estimation or recursive estimation. A technical benefit may include that the accuracy of the estimated one or more energy storage properties may be maintained even in operating regions where the energy storage system operates non-linearly.

Optionally in some examples, including in at least one preferred example, the vehicle may comprise a first energy storage system provided as a fuel cell system and a second energy storage system provided as a battery system. The processing circuitry may be further configured to during use of the fuel cell system or the battery system obtain operational data associated with one or more operational properties of the present operation of said fuel cell system or battery system, determine the present operating region of the fuel cell system or the battery system based on the operational data, estimate one or more energy storage properties of the fuel cell system or battery system based on the determined present operating region, and control the power transfer to and/or from the fuel cell system or battery system based on the estimated one or more energy storage properties. A technical benefit may include that a more energy-efficient vehicle may be achieved due to the computer system enabling control of multiple energy storage system to find an energy-efficient way of powering components of the vehicle.

Optionally in some examples, including in at least one preferred example, the one or more present operational properties may comprise a stack current, a state of charge of the energy storage system, a pressure in the energy storage system and/or a stack temperature of the energy storage system, wherein the processing circuitry may further configured to determine the present operating region as a subset of the total operating range of the energy storage system. Optionally, the processing circuitry may be further configured to obtain a stack voltage of the energy storage system, obtain a DC-DC output current and DC-DC output voltage of the energy storage system, obtain the stack voltage and stack current based on the DC-DC output current and DC-DC output voltage and a model of a DC-DC converter of the vehicle connected to the energy storage system and estimate the one or more energy storage properties of the energy storage system based on the determined present operating region and the stack voltage. Optionally, the processing circuitry may configured to determine a measure of uncertainty for the estimated one or more energy storage properties and control the power transfer to and/or from the energy storage system based on the measure of uncertainty.

According to a second aspect of the disclosure, a vehicle is provided. The vehicle may comprise the computer system according to any of the examples described herein. The second aspect of the disclosure may seek to achieve a more energy-efficient vehicle. A technical benefit may include that the performance of the energy storage system may be monitored and predicted in a more accurate manner, allowing for a more optimized energy efficiency by controlling the usage of the energy storage system based on its present and predicted performance in its present operating region.

Optionally in some examples, including in at least one preferred example, the vehicle may further comprise a fuel cell system comprising a fuel cell stack and a battery system comprising a vehicle battery.

According to a third aspect of the disclosure, a computer-implemented method is provided. The computer-implemented method comprises during use of an energy storage system of a vehicle, obtaining, by processing circuitry of a computer system, operational data associated with one or more operational properties of the present operation of the energy storage system, determining, by the processing circuitry, a present operating region of the energy storage system based on the operational data, estimating, by the processing circuitry, one or more energy storage properties of the energy

**EP 4 696 539 A1**

storage system based on the present operating region, and controlling, by the processing circuitry, the power transfer to and/or from the energy storage system based on the estimated one or more energy storage properties. The third aspect of the disclosure may seek to achieve a more energy-efficient method of controlling an energy storage system of a vehicle. A technical benefit may include that the performance of the energy storage system may be monitored and predicted in a more accurate manner, allowing for a more optimized energy efficiency by controlling the usage of the energy storage system based on its present and predicted performance in its present operating region.

Optionally in some examples, including at least one preferred example, the computer-implemented method may further comprise obtaining, by the processing circuitry, a stack voltage of the energy storage system, and estimating, by the processing circuitry, the one or more energy storage properties of the energy storage system based on the determined present operating region and the stack voltage. A technical benefit may include that the one or more energy storage properties may be estimated in a more accurate manner.

Optionally in some examples, including in least one preferred example, the computer-implemented method may further comprise determining, by the processing circuitry, a measure of uncertainty for the estimated one or more energy storage properties, and controlling, by the processing circuitry, the power transfer to and/or from the energy storage system based on the measure of uncertainty. A technical benefit may include an improved predictability and accuracy for the control of the energy storage system, since, the method may take into account potential inaccuracies in the estimation.

Optionally in some examples, including in at least one preferred example, the vehicle may comprise a first energy storage system provided as a fuel cell system and a second energy storage system provided as a battery system. The computer-implemented method may further comprise during use of the fuel cell system or the battery system, obtaining, by the processing circuitry, operational data associated with one or more operational properties of the present operation of said fuel cell system or battery system, determining, by the processing circuitry, the present operating region of the fuel cell system or the battery system based on the operational data, estimating, by the processing circuitry, one or more energy storage properties of the fuel cell system or battery system based on the determined present operating region, and controlling, by the processing circuitry, the power transfer to and/or from the fuel cell system and the power transfer to and/or from the battery system based on the estimated one or more energy storage properties. A technical benefit may include that a more energy-efficient vehicle may be achieved due to the computer system enabling control of multiple energy storage system to find an energy-efficient way of powering components of the vehicle.

According to a fourth aspect of the disclosure a computer program product is provided. The computer program product comprises program code for performing, when executed by the processing circuitry, the computer-implemented method of any of the examples described herein.

According to a fifth aspect of the disclosure a non-transitory computer-readable storage medium is provided. The non-transitory computer-readable storage medium comprises instructions, which when executed by the processing circuitry, cause the processing circuitry to perform the computer-implemented method of any of examples described herein.

The disclosed aspects, examples (including any preferred examples), and/or accompanying claims may be suitably combined with each other as would be apparent to anyone of ordinary skill in the art. Additional features and advantages are disclosed in the following description, claims, and drawings, and in part will be readily apparent therefrom to those skilled in the art or recognized by practicing the disclosure as described herein.

There are also disclosed herein computer systems, control units, code modules, computer-implemented methods, computer readable media, and computer program products associated with the above discussed technical benefits.

**BRIEF DESCRIPTION OF THE DRAWINGS**

Examples are described in more detail below with reference to the appended drawings.

**FIG. 1** is an exemplary system diagram of a vehicle and a computer system according to an example.
**FIG. 2** is an exemplary block diagram of a computer system according to an example.
**FIG. 3** is a block diagram schematically illustrating aspects of the computer system of **FIG. 2** according to an example.
**FIG. 4** is a block diagram schematically illustrating aspects of the computer system of **FIG. 2** according to an example.
**FIG. 5** is a graph depicting the characteristics of an operation of an energy storage system according to an example.
**FIG. 6A** is a block diagram depicting a computer system according to an example.
**FIG. 6B** is a flow-chart depicting aspects of the operation of the computer system of **FIG. 6A** according to an example.
**FIG. 6C** is a graph depicting the characteristics of an operation of an energy storage system according to an example.
**FIG. 7** is a flow-chart depicting a computer-implemented method according to an example.
**FIG. 8** is a flow-chart of the computer-implemented method of FIG. 7 according to an example.
**FIG. 9** is a schematic diagram of an exemplary computer system for implementing examples disclosed herein, according to an example.

DETAILED DESCRIPTION

The detailed description set forth below provides information and examples of the disclosed technology with sufficient detail to enable those skilled in the art to practice the disclosure.

The detailed description set forth below provides information and examples of the disclosed technology with sufficient detail to enable those skilled in the art to practice the disclosure.

As discussed in the background section, the efficiency of a fuel cell system and a battery system may vary depending on the present conditions. For example, a fuel cell system and/or a battery system may in certain operating regions in terms of state of charge, stack current, temperature, pressure, voltage etc. operate more or less energy efficient. Thus, there may be operating regions where the battery system and/or fuel cell system may be capable of providing power with lower losses and operating regions where the battery system and/or fuel cell system may provide power with higher losses. A problem to be solved by the present disclosure may thus be seen in in how to improve the energy-efficiency of the vehicle. In some case, a vehicle may comprise more than one power source for powering the propulsion and/or components of the vehicle. A problem to be solved by the present disclosure may thus be seen in improving the control of the utilization of the battery system and/or fuel cell system to improve the energy-efficiency of the vehicle.

A typical scenario that can be realized is that a vehicle comprising one or more energy storage system in the form of a battery system and/or a fuel cell system is operating. During the operation and consequent use of the one or more energy storage system, the operating region of each energy storage system may shift due to a number of parameters changing due to charging and discharging, temperature, pressure etc. Since each operating region of an energy storage system may be associated with an estimated energy efficiency, the utilization, e.g. the power transfer to and from each energy storage system, may be controlled such that utilization of an energy storage system in an energy efficient operating region may be increased and the utilization of an energy storage system in a less energy efficient operating region may be decreased. For example, an energy storage system in an energy efficient operating region may be utilized to a higher degree for powering the propulsion and/or components of the vehicle while an energy storage system in a less energy efficient operating region may be utilized for regenerative charging or may be idle.

A more specific typical scenario that can be realized is that a vehicle may comprise both a fuel cell system and a battery system for powering a propulsion source, e.g. an electrical motor, for propelling the vehicle. In such cases, the system and method according to the present disclosure may be utilized to control the power transfer to said propulsion source from each of the battery system and the fuel cell system to prioritize the energy storage system being in a more favorable operating region.

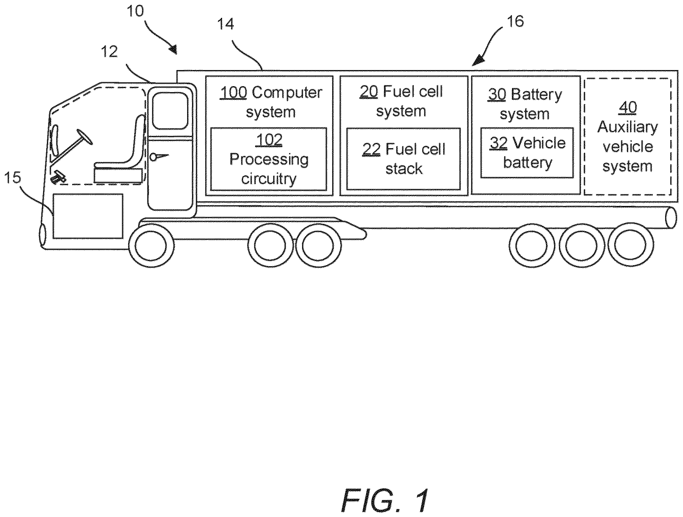

FIG. 1 is an exemplary schematic illustration of a vehicle. The vehicle may comprise one or more energy storage systems **16**. The one or more energy storage systems **16** may comprise a fuel cell system **20** and/or a battery system **30**. In the depicted example, the one or more energy storage system **16** comprises a first energy system in the form of a fuel cell system **20** and a second energy storage system in the form a battery system **30**. It may however be envisioned that the vehicle **10** only comprises a fuel cell system **20** or only a battery system **30**. It may be envisioned that the vehicle **10** also comprises a combustion engine in addition to the above energy storage system(s).

The one or more energy storage systems **16** may be configured to power a propulsion source **15** of the vehicle **10**. The propulsion source **15** may be configured to propel the vehicle **10**. The propulsion source **15** may be an electric motor **15**.

Referencing **FIG. 1,** the vehicle may be an FCEV **10**. The vehicle **10** is illustrated as a heavy-duty vehicle, but other vehicle types may be used. The vehicle **10** comprises a tractor unit **12** which is arranged to tow a trailer unit **14**. In other examples, other heavy-duty vehicles may be employed, e.g., trucks, buses, and construction equipment. The vehicle **10** comprises vehicle units and associated functionality as would be understood and expected by a skilled person, such as a powertrain, chassis, and various control systems.

The vehicle **10** may comprise a fuel cell system **20** having a fuel cell stack **22** with a plurality of fuel cells. The fuel cell system **20** is adapted to convert chemical energy stored in a fuel, typically hydrogen, as well as an oxidizing agent, typically oxygen or air, into electricity and heat as a byproduct through continuous electrochemical reactions. Each fuel cell comprises an anode where the fuel is oxidized, and a cathode where the oxidizing agent is reduced. Hydrogen fuel is supplied at the anode and undergoes an electrochemical oxidation, typically facilitated by a catalyst, such as platinum. Electrons produced at the anode cannot pass through the electrolyte, thereby forcing them to flow through an external circuit for generating an electric current used to power the propulsion source **15** for propulsion purposes, charge a vehicle battery **32,** and/or power auxiliary vehicle systems **40** of the vehicle **10**. At the same time, a reduction reaction occurs at the cathode where oxygen is supplied in combination with the protons and electrons from the external circuit to form water.

The vehicle **10** comprises a battery system **30**. In the depicted example, the battery system **30** comprises the vehicle battery **32**. In the depicted example, the vehicle battery **32** may be connected to the fuel cell system **20** to be charged by means of said fuel cell system **20**. It may however be envisioned that the fuel cell system **20** may be connected to a dedicated fuel cell system battery, said fuel cell battery being configured to power the propulsion source **15** and/or power the auxiliary vehicle systems **40**. It may also be envisioned that the fuel cell system **20** is configured to power the propulsion source **15** and/or other components of the vehicle **10** directly, e.g. without charging a battery in turn powering the propulsion source **15** and/or other components of the vehicle **10.**

As is conventional, the battery system **30** may comprise a battery management system. The battery management system may be adapted to monitor, protect and optimize the performance of the vehicle battery **32,** thereby ensuring safe and efficient operation and prolonging the lifetime expectancy of the vehicle battery **32.** The vehicle battery **32,** being for instance a lithium-ion battery, is used to store electrical energy in the form of chemical energy. The vehicle battery **32** is rechargeable and adapted to provide a source of electricity for the propulsion source **15** of the vehicle **10.** The vehicle battery **32** may serve as an energy buffer for obtaining surplus electricity generated by the fuel cell system **20** beyond what the electric motor currently needs. The surplus energy stored in the vehicle battery **32** may subsequently be used for powering the electric motor, or other auxiliary vehicle systems **40,** of the vehicle **10.** Hence, by combining the fuel cell system **20** and the vehicle battery **32,** a power supply system for the vehicle **10** is realized.

The vehicle battery **32** may comprise one or more battery packs, each comprising battery cells.

The vehicle **10** may comprise one or more auxiliary vehicle systems **40.** The auxiliary vehicle systems **40** provide additional functionalities beyond the primary power source of the vehicle **10,** i.e., the propulsion source **15.** Auxiliary vehicle systems **40** may include one or more of power take-off (PTO) systems, hydraulic systems, air compression systems, auxiliary generators, cooling systems, power steering systems, air conditioning systems, auxiliary lighting systems, infotainment systems, and the like. The auxiliary vehicle systems **40** are associated with respective auxiliary power consumptions that affect the operation of the vehicle **10.**

The vehicle **10** comprises a computer system **100** having processing circuitry **102.** In some optional implementations, operations of the processing circuitry **102** is carried out external to the vehicle **10,** for instance by a cloud-computing service. In these implementations, the vehicle **10** involves a communication module configured to receive and send information to and from the cloud-computing service.

The processing circuitry **102** is configured to during use of the energy storage system **16** of the vehicle **10,** obtain operational data. The operational data is associated with one or more operational properties of the present operation of the energy storage system **16.** The processing circuitry **102** is configured to determine a present of the energy storage system **16** based on the operational data. The processing circuitry **102** is configured to estimate one or more energy storage properties of the energy storage system based on the determined present operating region. The processing circuitry **102** is configured to control the power transfer to and/or from the energy storage system **16** based on the estimated one or more energy storage properties.

Depending on the type of energy storage system **16,** the controlling the power transfer may comprise controlling power provided to the energy storage system **16,** e.g. to charge the energy storage system **16** and/or controlling power transfer from the energy storage system **16,** e.g. the power provided by the energy storage system **16,** for example to power components of the vehicle **10.**

In use may herein refer to operation of the energy storage system **16,** e.g. during power transfer from or to the energy storage system **16** or transfer of electrical current to or from the energy storage system **16.** In use may be in contrast to an idle state of the energy storage system **16** wherein no power transfer, e.g. transfer of current, to or from the energy storage system **16** takes place.

The processing circuitry **102** may be configured to control the power transfer between the energy storage system **16** to power the vehicle **10,** e.g. controlling power transfer to the propulsion source **15** of the vehicle **10** and/or from the propulsion source **15** of the vehicle, e.g. by means of regenerative charging.

In addition or alternatively, the processing circuitry **102** may be configured to control the power transfer between the energy storage system **16** and the one or more auxiliary vehicle systems **40.**

An energy storage system may be considered a power source. Thus, any energy storage system mentioned herein may analogously be considered a power source of the vehicle **10.**

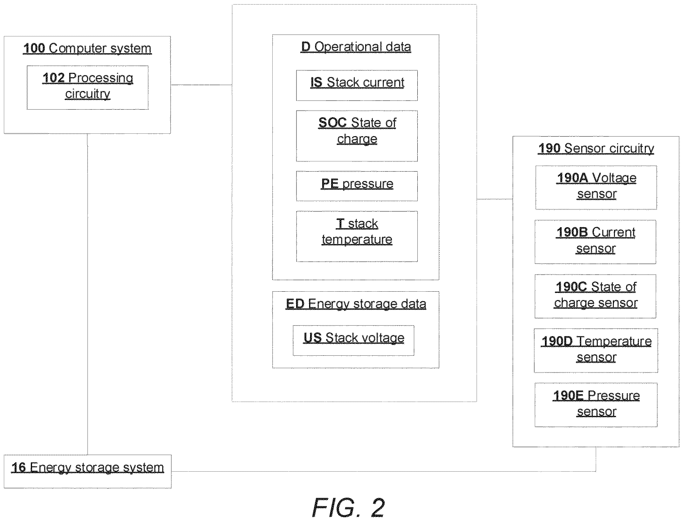

The above-described procedures will now be explained in detail with further reference to **FIG. 2.**

As aforementioned, the processing circuitry **102** may be configured to determine an operating region. The operating region may refer to a region defined by a subset of a total range of one or more parameter associated with the operation of the energy storage system **16.** Hence, the processing circuitry **102** may be configured to determine the present operating region **O** as a subset of the total operating range of the energy storage system **16.** An operating region may be associated with estimated characteristics of the energy storage system **16** distinguished from estimated characteristics of another operating region of said energy storage system **16.** Accordingly, each operating region as defined herein may be distinguished from the others with reference to the estimated characteristics of the energy storage system **16.**

The one or more operational properties may be associated with the present operation of the energy storage system **16.** Thus the operational properties may be configured to provide an indication of the present properties of the energy storage system **16.** The operational data **D** may be associated with said one or more operational properties.

In the depicted example, the operational data **D** may be obtained based on sensor data provided by sensor circuitry **190.** The sensor circuitry **190** may be configured to monitor the energy storage system **16.** The sensor circuitry **190** may be configured to monitor the aforementioned operational properties. As will be described in further detail later on, the sensor circuitry **190** may comprise a plurality of sensors configured to monitor any number of operational properties. It may also be envisioned that the sensor circuity **190** may be configured to monitor other properties as well, e.g. properties not utilized for determining of an operating region of the energy storage system **16**.

The sensor circuitry **190** may be operatively connected to the computer system 100, e.g. the processing circuitry **102**. The computer system **100,** e.g. the processing circuitry 102, may be configured to obtain the operational data **D** from the sensor circuitry **190**.

The operational data **D** may form the basis for determining the operating region of the energy storage system **16**. The operating region may be based on the operational data **D,** e.g. one or more operational property associated with the obtained operational data **D**.

Further referencing **FIG. 2,** the one or more operational properties may comprise one or a plurality of a stack current **IS** of the energy storage system **16,** a state of charge **SOC** of the energy storage system **16,** a pressure **PE** in the energy storage system **16** and a stack temperature **T** of the energy storage system **16**.

The operating region may thus be defined by any of said operational properties. Hence, it may be a combined operating region defined by an interval of a plurality of operational properties or an operating region defined by a single operational property.

A stack current **IS,** as the skilled person is well aware, refers to the electric current flowing through a series of electrochemical cells, such as those in a battery stack or fuel cell stack. It represents the total current produced or consumed by the stack as a whole. Accordingly, the stack current **IS** may be the stack current of the fuel cell stack **22,** e.g. the total current flowing through the cells of the fuel cell stack **22** or the stack current of the cells of the vehicle battery **32** of the battery system **30,** e.g. the total current flowing through the battery cells of said vehicle battery **32**. The sensor circuitry **190** may accordingly comprise a current sensor **190B** configured to monitor, e.g. measure, said stack current **IS** of the energy storage system **16** or a current from which the stack current **IS** may be derived.

In battery systems, a state of charge sensor **190C** is commonly utilized (often instead of a sensor for monitoring the stack current). The sensor circuitry **190** may comprise a state of charge sensor **190** configured to monitor the state of charge of the battery system **30,** e.g. the vehicle battery **32**.

The one or more operational properties may comprise the stack temperature **T,** the stack temperature **T** in the energy storage system **16** may be considered the temperature in the fuel cell stack **22** or inside the vehicle battery **32,** e.g. in inside a housing of said vehicle battery **32**. The sensor circuitry **190** may comprise a temperature sensor **190D**. The temperature sensor **190D** may be configured to monitor, e.g. measure, the temperature **T** in the energy storage system **16**.

The one or more operational properties may comprise the pressure **PE,** the pressure **PE** in the energy storage system **16** may be considered the pressure in the fuel cell stack **22** or inside the vehicle battery **32,** e.g. in inside a housing of said vehicle battery **32**. The sensor circuitry **190** may comprise a pressure sensor **190E**. The pressure sensor **190E** may be configured to monitor, e.g. measure, the pressure in the energy storage system **16**.

Each of the one or more operational properties, e.g. the value or magnitude of each one or more operational property, may affect the efficiency of the energy storage system **16,** whereby the computer system **100** may control the energy storage system **16** based on estimations of energy storage properties associated with a present operating region corresponding to the present operational properties.

The relevant energy storage properties may differ depending on the nature of the energy storage system **16**.

It may be envisioned that the energy storage property is based on the operational properties which the operational data **D** is associated with. It may also be envisioned that the processing circuitry **102** is configured to obtain additional data for estimating the one or more energy storage properties.

In **FIG. 2** this is illustrated by the processing circuitry **102** being configured to obtain energy storage data **ED** associated with the energy storage **16**. The energy storage data **ED** may be obtained based on sensor data, e.g. sensor data obtained from the sensor circuitry **190**. In the depicted example, the energy storage data **ED** comprises a stack voltage **US** of the energy storage system **16**. The sensor circuitry **190** may comprise a voltage sensor **190A** configured to monitor, e.g. measure, the stack voltage **US**.

A stack voltage may refer to the total output voltage of the fuel cell system **20** or the battery system **30**. The total output voltage may be the sum of the individual voltages of all the fuel cells in the fuel stack **32** or all the battery cells of the vehicle battery **32** connected in series within said fuel cell stack **32** or vehicle battery **32**. The stack voltage **US** may represent the usable electrical power generated by the entire fuel cell system **20** or battery system **30**.

As depicted, the energy storage system **16** as described with reference to **FIG. 2** may be provided as the battery system **30** or the fuel cell system **20**.

In one example, the energy system **16** may be the fuel cell system **20**. According to such an example, the one or more energy storage properties may be any one of or a plurality of a Nernst voltage, ohmic losses and/or activation losses of the fuel cell system **20**.

A Nernst voltage, also known as the Nernst potential, of the fuel cell system **20** may be considered the theoretical voltage generated by the fuel cell system **20** under ideal conditions. The processing circuitry **102** may be configured to estimate the Nernst voltage based on the pressure PE in the fuel cell system **20,** e.g. the fuel cell stack **22** and the stack temperature **T** in the fuel cell system **20,** e.g. the fuel cell stack **22** and/or based on the stack current **IS** and the stack voltage **US** of the fuel cell system **20,** e.g. the fuel cell stack **22.**

Ohmic losses may refer to the energy lost as heat due to the resistance to the flow of electric current within the fuel cell system **20.** The ohmic losses may be estimated based on the internal resistance of the components of the fuel cell system **20** or the stack voltage of the fuel cell system **20,** e.g. the fuel cell stack **22,** and the stack current **IS** of the fuel cell system **20.** Data comprising the internal resistance of the components of the fuel cell system **20** may be stored in a non-volatile memory. The processing circuitry **102** may be configured to access said non-volatile memory to obtain said data.

Activation losses may refer to the voltage losses that occur due to the energy required to initiate the electrochemical reactions at the electrodes in the fuel cell system **20.** The activation losses may be estimated based on the stack temperature **T** and the stack current **IS** and potentially the stack current **US.**

In one example, the energy storage system **16** may be the battery system **30.** According to such an example, the one or more energy storage properties may be any one of or a plurality of an open-circuit voltage, ohmic losses and/or activation losses of the battery system **30.**

Somewhat analogous to the Nernst voltage in a fuel cell system **20,** the open-circuit voltage of the battery system **30** may be considered the theoretical voltage generated by the battery system **30** when no load is connected to said battery system **30.** The processing circuitry **102** may be configured to estimate the open-circuit voltage at least based on the stack voltage **US** and advantageously based on the stack voltage **US** and the stack current **IS.**

Ohmic losses may refer to the energy lost as heat due to the resistance to the flow of electric current within the battery system **30.** The ohmic losses may be estimated based on the internal resistance of the components of the battery system **30** or the stack voltage of the battery system **30,** e.g. the vehicle battery **32,** and the stack current **IS** of the battery system **30.** Data comprising the internal resistance of the components of the battery system **30** may be stored in a non-volatile memory. The processing circuitry **102** may be configured to access said non-volatile memory to obtain said data.

Activation losses may refer to the voltage losses that occur due to the energy required to initiate the electrochemical reactions at the electrodes in the battery system **30.** The activation losses may be estimated based on the stack temperature **T** and the stack current **IS** and potentially the stack voltage **US.**

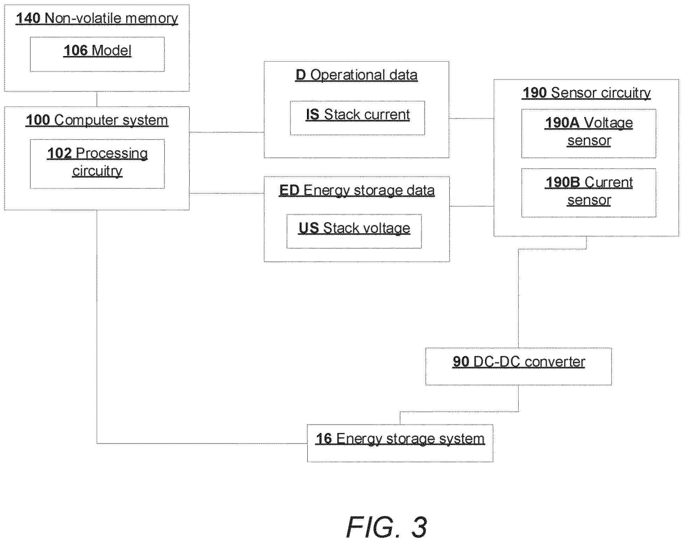

**FIG. 3** schematically depicts a particular example of aspects relating to the estimation of one or more energy storage properties.

As depicted, the processing circuitry **102** may be configured to obtain a stack voltage **US** of the energy storage system **16** and a stack current **IS** of the energy storage system **16.**

In the depicted example, the one or more energy storage properties may be estimated based on the stack voltage **US** of the energy storage system **16** and the determined present operating region. In the depicted example, the depicted present operating region may be determined based on the stack current **IS.**

The stack voltage **US** and the stack current **IS** may be obtained based on sensor data obtained from the sensor circuitry **190.** The sensor circuitry **190** may thus comprise an electric voltage sensor **190A** configured to measure a voltage associated with the energy storage system **16.** The sensor circuitry **190** may further comprise an electric current sensor **190B** configured to measure a current associated with the energy storage system **16.**

The voltage sensor **190A** may be configured to measure the stack voltage **US** and the current sensor **190B** may be configured to measure the stack current **IS.**

However, commonly, sensors and accompanying circuitry are provided outside of the energy storage system **16** in the vehicle **10** for practical reasons. Hence, it may be advantageous to base the estimation of the one or more energy storage properties on sensor data obtained from sensors arranged outside of the energy storage system **16.** Such an example is depicted **FIG. 3.**

In the depicted example, the processing circuitry **102** may be configured to obtain a DC-CD output current and a DC-output voltage of the energy storage system **16.** The processing circuitry **102** may configured to obtain the stack voltage **US** and the stack current **IS** based on the DC-DC output current and the DC-DC output voltage and a model **106** of a DC-DC converter **90** of the vehicle **10** connected to the energy storage system **16.**

The DC-DC output current and the DC-DC output voltage may be obtained at a location downstream of the DC-DC converter **90** relative to the energy storage system **16.** Accordingly the energy storage system **16** may be arranged upstream from the DC-DC converter **90.** Upstream and downstream may herein refer to an electric current direction extending away from the energy storage system **16.** In one example, the DC-DC converter **90** may be arranged between the propulsion source **15** and the energy storage system **16.**

The voltage sensor **190A** may be configured to measure the DC-DC output voltage. The processing circuitry **102** may be configured to obtain the stack voltage **US** based on the DC-DC output voltage obtained from said voltage sensor **190A.**

The current sensor **190B** may be configured to measure the DC-DC output current. The processing circuitry **102** may be configured to obtain the stack current **IS** based on the DC-DC output current obtained from said current sensor **190B.**

As aforementioned, the stack voltage **US** and the stack current **IS** may be further determined based on a model **106** of the DC-DC converter **90.** The model **106** may be a model **106** configured to utilize the DC-DC converter output current and the DC-DC converter output voltage as input parameters for the calculation of the stack current **IS** and the stack voltage **US.** The model **106** may be based on a set of functions and/or previous measured data.

The model **106** may be stored in a non-volatile memory **140.** The processing circuitry **102** may be configured to be operatively connected to the non-volatile memory **140** to access the model **106.** In the depicted example, the non-volatile memory **140** may be provided outside of the computer system **100** but it may be envisioned that the non-volatile memory **140** is provided as a component of the computer system **100.**

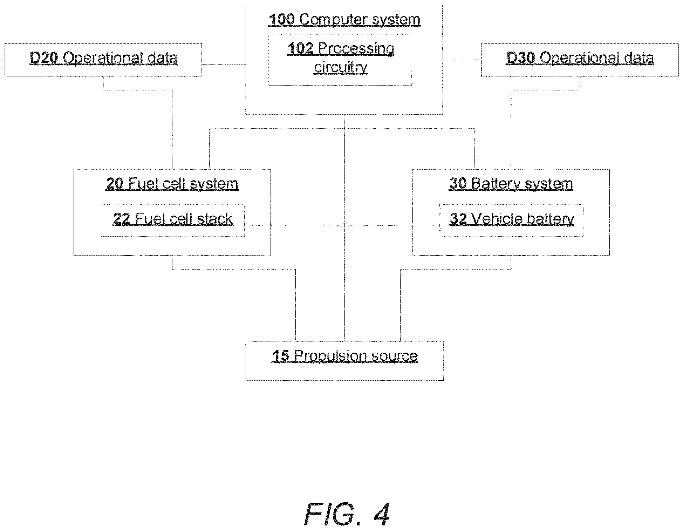

**FIG. 4** schematically depicts aspects of a vehicle **10** comprising a plurality of energy storage systems.

The first and second energy storage system may both be configured to provide power to the propulsion source **16** and/or the auxiliary vehicle systems **40.** The processing circuitry **102** may be configured to control the power provided to and/or from the first and second energy storage system based on the estimated energy storage properties of the first and second energy storage system.

In one example, the first energy storage system may be a battery system or fuel cell system while the second may be a provided as a combustion power system. According to such an example, only the operation of the first energy storage system may be controlled and estimated in accordance with the examples described herein.

In another example, where the first and second energy storage system are provided as fuel cell systems and/or battery systems, the operation of each energy storage system may be controlled and estimated in accordance with the examples described herein.

In the depicted example, the vehicle **10** may comprise a first energy storage system provided as the fuel cell system **20.** The vehicle **10** may comprise a second energy storage system provided as the battery system **30.**

The processing circuitry **102** may be configured to during use of the fuel cell system **20** or the battery system **30** obtain operational data **D** associated with one or more operational properties of the present operation of the fuel cell system **20** or the battery system **30.**

During use of the fuel cell system **20,** the processing circuitry **102** may be configured to obtain operational data **D** associated with the one or more operational properties of the present operation of the fuel cell system **20.** The operational data **D** may be considered fuel cell system operational data **D20** (as referenced in **FIG. 4**).

During use of the battery system **30,** the processing circuitry **102** may be configured to obtain operational data **D** associated with the one or more operational properties of the present operation of the battery system **30.** The operational data **D** may be considered battery system operational data **D30** (as referenced in **FIG. 4**).

In accordance with the examples discussed with reference to **FIG. 1-3,** the processing circuitry **102** may be configured to determine the present operating region of the fuel cell system **20** or the battery system based on the operational data **D.**

Thus, during use of the fuel cell system **20,** the processing circuitry **102** may be configured to determine the present operating region of the fuel cell system **20,** e.g. based on the fuel cell system operational data **D20.** The present operating region may thus be considered a present fuel cell system operating region.

During use of the battery system **30,** the processing circuitry **102** may be configured to determine the present operating region of the battery system **30,** e.g. based on the battery system operational data **D30.** The present operating region may thus be considered a present battery system operating region.

The processing circuitry **102** may be configured to estimate one or more energy storage properties of the fuel cell system **20** or battery system **30** based on the determined present operating region.

During use of the fuel cell system **20,** the processing circuitry **102** may be configured to estimate the one or more energy storage properties, e.g. the one or more fuel cell system properties, based on the determined present fuel cell system operating region.

During use of the battery system **30,** the processing circuitry **102** may be configured to estimate the one or more energy storage properties, e.g. the one or more battery system properties, based on the determined present battery system operating region.

The processing circuitry **102** may be configured to control the power transfer to and/or from the fuel cell system **20** or battery system **30** based on the estimated one or more energy storage properties. Thus, referencing the depicted example, the processing circuitry **102** may be configured to control the power transfer to the propulsion source **15** from the fuel cell system **20** and the battery system **30** based on the estimated one or more energy storage properties of the energy storage system currently in use, e.g. the battery system **30** and/or the fuel cell system **20.**

Referencing **FIG. 4,** the processing circuitry **102** may be configured to control the power transfer to the propulsion source **15** from the battery system **30** and/or fuel cell system **20.** The processing circuitry **102** may estimate for the one of the battery system **30** and the fuel cell system **20** currently being in use for powering the propulsion source **15** the one or more energy storage properties of said battery system **30** or fuel cell system **20** being in use and control the power transfer from said battery system **30** or fuel cell system **20** being in use to the propulsion source **15** based on the estimated one or more energy storage properties.

In the depicted example, the fuel cell system **20** is electrically connected to the vehicle battery **32** of the battery system **30** such that superfluous power provided by the fuel cell system **20** is used to charge the vehicle battery **32,** but it may be envisioned that the fuel cell system **20** and the battery system **30** operates completely independent from each other.

In one example, if a value of said one or more estimated properties is outside of an energy storage property threshold, the processing circuitry **102** may be configured to control the battery system **30** and the fuel cell system **20** such that the one of the battery system **30** and the fuel cell system **20** currently being in use is switched. Hence, if one of the battery system **30** and the fuel cell system **20** is currently powering the propulsion source **15,** the processing circuitry **102** may be configured to control said one of the battery system **30** and the fuel cell system **20** to stop powering said propulsion source **15** and the other of said fuel cell system **20** and battery system **30** to start powering said propulsion source **15.**

In one example, if a value of said one or more estimated properties is within an allowed energy storage property threshold, the processing circuitry **102** may be configured to control the battery system **30** and the fuel cell system **20** such that the one of the battery system **30** and the fuel cell system **20** currently being in use is maintained in use. Hence, if one of the battery system **30** and the fuel cell system **20** is currently powering the propulsion source **15,** the processing circuitry **102** may be configured to control said one of the battery system **30** and the fuel cell system **20** to keep powering said propulsion source **15.**

It may envisioned that the control of power provided by the energy storage system **16** may be controlled based on other parameters in addition to the estimated one or more energy storage properties. Hence, the selection between the fuel cell system **20** and the battery system **30** for powering components such as the propulsion source **15** and/or the auxiliary vehicle systems **40** may be based on additional parameters.

In one example, the power transfer to and/or from each energy storage system **16,** e.g. the fuel cell system **20** and the battery system may be controlled based on the minimum and/or maximum power limits of each energy storage system **16,** predetermined activation losses for each energy storage system **16** etc.

Hence, to exemplify, although it may be determined that the energy storage system **16** in use is not favorable based on the estimated one or more energy storage properties, it may be determined that a switch to the other energy storage system **16** is non-desirable due to the vehicle **10** operating at for example higher speeds causing the power to be requested of the other energy storage system **16** to exceed its maximum power limit. Thus, the energy storage system **16** currently in use may remain in use.

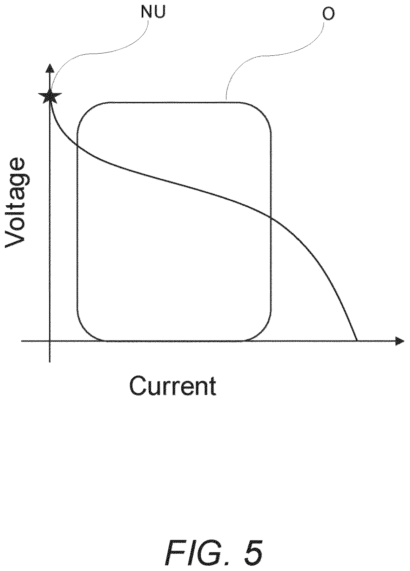

FIG. 5 schematically depicts an exemplary graph of the characteristics of an energy system. The depicted examples shows the characteristics of a fuel cell system **30** it may however be envisioned that it may be a battery system **30** as well.

FIG. 5 depicts a present operating region **O.** The present operating region **O** is determined as a subset of the total operating range of the energy storage system **16.** The present operating region **O** may be defined by the one or more operational properties of the present operation of the energy storage system **16.**

In the depicted example, the one or more operational properties of the present operation of the energy storage system **16** comprises the stack current **IS.** In the depicted example, the stack current **IS** is the only operational property taken into consideration. Thus the total operating range is defined by the total stack current range, e.g. the total possible range of stack current obtainable in the energy storage system **16.** The present operating region **O** may be defined as a subset of said total stack current range.

It may however be envisioned that other any other relevant operational property affecting the operation of the energy storage system **16** may be utilized in a similar manner, i.e. to determine a present operating region for the control of the power transfer to and/or from the energy storage system **16.** For example, for the fuel cell system **30,** this may include temperature, pressures of H2, 02, H2O, etc. fuel cell status parameters such as the age of the fuel cell stack **22** etc.

In the depicted example, the stack voltage **US** is utilized together with the stack current **US** to estimate an energy storage property in the form of a Nernst voltage **NU.** The Nernst voltage **NU** may be associated with a present operating region **O.** Thus, the energy storage property, e.g. the Nernst voltage **NU,** may be determined based on a present operating region **O** determined based on the stack current **IS.** In addition, the energy storage property, e.g. the Nernst voltage **NU,** may be determined also based on an additional parameter (not required for determining the present operating region **O** in itself), e.g. the stack current **US.**

The present operating region **O** may allow for predictive control of the power transfer to and/or from the energy storage system **16** as the energy storage property and potential changes in said energy storage property may be estimated for the entire present operating region **O.**

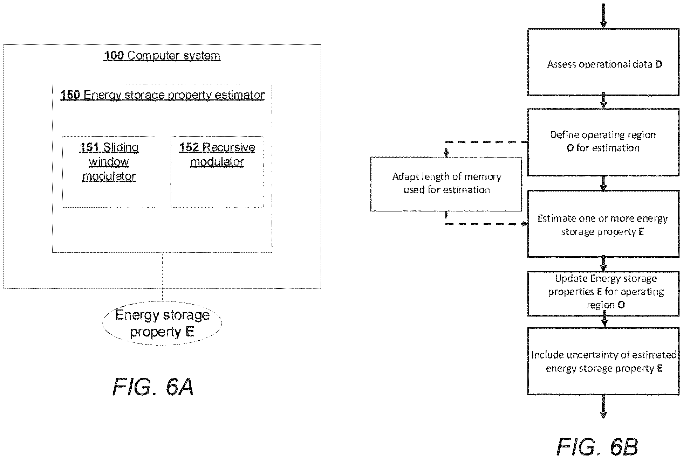

FIG. 6A-C schematically depicts exemplary aspects further explaining how the energy storage property may be determined in further detail.

The estimation of the one or more energy storage properties **E** can be done recursively or in a sliding window, for piecewise linear (affine) operating regions of the energy storage system **16,** for example by partitioning the nonlinear characteristic of an operating region into quasi linear segments. The properties may in some examples include a measure of uncertainty or error in the way of confidence interval, standard deviation, or variance.

FIG. 6A a system diagram of an energy storage property estimator **150** is shown. The energy storage property estimator **150** is configured to estimate the one or more energy storage properties **E**. The functions of the energy storage property estimator **150** are advantageously performed by the processing circuitry **102** of the computer system **100**.

In one example, the processing circuitry **102**, e.g. the energy storage property estimator **150**, may be configured to determine a measure of uncertainty for the estimated one or more energy storage properties **E** and control the power transfer to and/or from the energy storage system **16** based on the measure of uncertainty.

The energy storage property estimator **150** may thus be configured to determine a measure of uncertainty or error value associated with the estimated one or more energy storage properties **E**. In one example, if the value is outside a set interval, the energy storage property estimator **150** may determine that the estimated one or more estimated energy storage property **E** is unreliable. Responsive to said determination, the energy storage property estimator **150** may be disable control of the energy storage system **16** based on said one or more estimated energy storage property **E**.

In one example, the measure of uncertainty may comprise a confidence interval, a standard deviation and/or a variance.

In one example, the processing circuitry **102**, e.g. the energy storage property estimator **150**, may be further configured to estimate the one or more energy storage properties **E** for the determined present operating region **O** based on sliding window estimation or recursive estimation.

The energy storage property estimator **150** may in one example comprise a sliding window modulator **151**. The sliding window modulator **151** may be configured to estimate the one or more energy storage properties **E** for the present operating region **O** by means of partitioning of the one or more energy storage properties **E** into quasi linear segments for the entire range of the present operating region **O**, e.g. by means of sliding window modulation. In one example, the sliding window modulator **151** may be configured to estimate the one or more energy storage properties **E** with a measure of uncertainty.

The energy storage estimator **150** may in one example comprise a recursive modulator **152**. The recursive modulator **152** may be configured to recursively estimate the one or more energy storage properties **E** for the present operating region **O**, i.e. by means of recursive estimation.

The recursive modulator **152** may implement a varying length of memory for the estimation of the one or more energy storage properties **E**. The length of the memory from the past used for the estimation may vary over time depending on the operation of the energy storage system **16**. The recursive modulator **152** may estimate the one or more energy storage properties **E** by means of a recursive least squares algorithm. The recursive least square algorithm may implement a forgetting factor $\lambda$. The forgetting factor $\lambda$ may vary over time depending on the operation of the energy storage system **16**. For example, during more transient operation, the memory may be shorter and during more steady-state operation the memory may be longer to cover a broader operating region.

The forgetting factor $\lambda$ may form a tuning parameter for the recursive least squares algorithm. In one example, the forgetting factor $\lambda$ may be between 0 and 1. A higher forgetting factor $\lambda$, e.g. a forgetting factor $\lambda$ approaching 1 may be associated with a lesser weight to older error samples.

In one example, the recursive modulator **152** may be configured to estimate the one or more energy storage properties **E** as follows.

A new input sample in the form of an operational property, e.g. the stack current IS, may be provided. The new input sample is herein denoted *f(n)* and may function as an input signal. In the algorithm, *d(n)* may represent the desired output, e.g. the estimated energy storage property **E**.

Initially, an input history vector **f**(*n*) may be updated based on the new input sample *f(n)*.

Subsequently, the filter output may be computed using the previous set of filter coefficients **b**(n-1):

$$y(n) = \mathbf{f}^T(n)\mathbf{b}(n-1)$$

Subsequently, the error may be computed:

$$e(n) = d(n) - y(n)$$

Subsequently, the Kalman gain vector may be calculated, where **R** represents a covariance or correlation matrix containing information of the uncertainty in the estimated parameters, e.g. the energy storage property **E**:

$$\mathbf{k}(n) = \frac{R^{-1}(n-1)f(n)}{\lambda + \mathbf{f}^T(n)\mathbf{R}^{-1}(n-1)\mathbf{f}(n)}$$

The matrix $\mathbf{R}^{-1}$(n) may be updated for the next iteration as follows:

$$\mathbf{R}^{-1}(n) = \lambda^{-1}[\mathbf{R}^{-1}(n-1) - \mathbf{k}(n)\mathbf{f}^T(n)\mathbf{R}^{-1}(n-1)]$$

The filter coefficient may also be updated for the next iteration in accordance with the below:

$$\mathbf{b}(n) = \mathbf{b}(n-1) + \mathbf{k}(n)e(n)$$

Thereby, the recursive modulator **152** may be configured to adapt the present operating region in accordance with the operation of the energy storage system **16.**

In another example, the recursive modulator **152** may be configured to implement a conventional Kalman filter. The implementation of such a Kalman filter is well-established and will not be discussed in further detail.

**FIG. 6B** schematically depicts the operation of the energy storage property estimator **150** according to an example.

In the example depicted in **FIG. 6B,** the energy storage property estimator **150** implements a recursive estimation and may comprise the recursive modulator **152.**

Initially the operational data **D** may assessed, e.g. to determine the one or more operational properties, e.g. values of said operational properties.

The operating region, e.g. the present operating region **O** may be defined based on the operational data **D.** The present operating region **O** may be considered to be the operating region for the estimation to be performed by the energy storage estimator **150.**

The one or more energy storage properties **E** may be recursively estimated with an adapted length of memory used for said estimation. The length of the memory may be adapted based on the characteristics of the present operating region **O.**

Subsequent to the recursive estimation of the one or more energy storage properties E, the energy storage properties **E** for the present operating region **O** may be updated.

As a final step, a measure of uncertainty may be calculated and included in the estimated energy storage properties **E** for forming the basis of the control of the power transfer to and/or from the energy storage system **16** performed by the processing circuitry **102** of the computer system **100.**

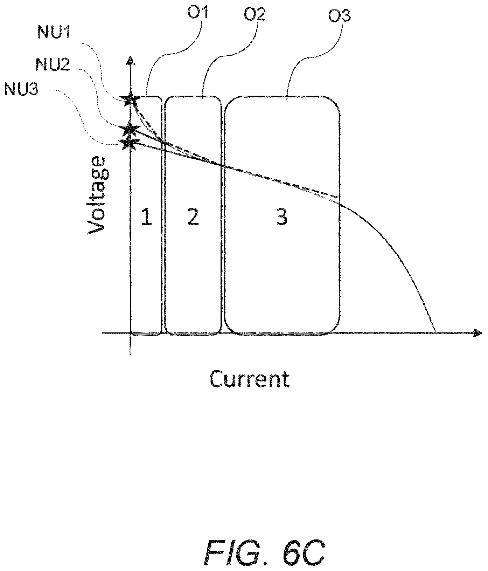

**FIG. 6C** depicts the characteristics of an energy storage system in the form of a fuel cell system **20** when operating in different operating regions.

**FIG. 6C** corresponds to the graph provided in **FIG. 4** but with the addition of additional defined operating regions.

In the depicted example, the stack current **IS** is divided into three operating regions **O1, 02, 03.**

In the depicted example, a first operating region **O1** may represent a minimum power region. The minimum power region may be associated with the time intervals just after the fuel cell system **30** starts to provide power to other components or just before the fuel cell system **20** terminates power transfer to other components.

In the depicted example, a second operating region **O2** may represent a low power region. The low power region may correspond to a relatively low power provided by the fuel cell system **20** to other components.

In the depicted example, a third operating region **O3** may represent a main region of operation for a medium to high power provided by the fuel cell system **20** to other components.

As depicted the first operating region **O1** and second operating region **O2** may be highly non-linear in terms of the stack voltage **US** provided in relation to the stack current **IS.** Further, the Nernst voltage **NU1-2** estimated for the first and second operating region **01, 02** is substantially lower the Nernst voltage **NU3** estimated for the third operating region **O3,** indicating that the losses of the fuel cell system **20** is substantially higher for the first and second operating region **O1, 02.**

By utilization of sliding window estimation or recursive estimation, the Nernst voltage **NU** may be more accurately determined both for the non-linear operating regions and the more linear operating regions, e.g. for the first, second and third operating region **01-3** (in the depicted example).

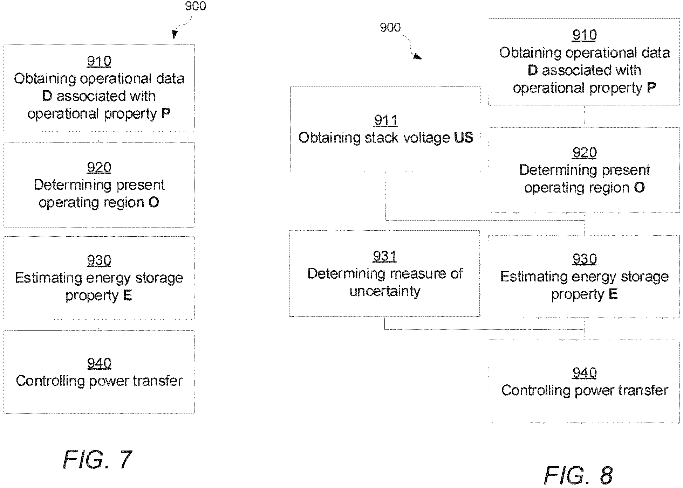

**FIG. 7** is a flow chart of a computer-implemented method **900.** The computer-implemented method **900** may be for controlling the power transfer to and/or from an energy storage system **16** of a vehicle **10,** such as the vehicle **10** described herein.

The method **900** may comprise a step **910** of during use of the energy storage system **16** of the vehicle **10,** obtaining operational data **D** associated with one or more operational properties **P** of the present operation of the energy storage system **16**. The method **900** may comprise a step **920** of determining a present operating region **O** of the energy storage system **16**. The method **900** may comprise a step **930** of estimating one or more energy storage properties **E** of the energy storage system **16** based on the present operating region **O**. The method **900** may comprise a step **940** of controlling the power transfer to and/or from the energy storage system **16** based on the estimated one or more energy storage properties **E**.

In one example, the vehicle **10** may comprise a first energy storage system provided as the fuel cell system **20** and a second energy storage system provided as the battery system **30**. The step **910** may comprise to during use of the fuel cell system **20** or the battery system **30** obtaining operational data **D** associated with one or more operational properties **P** of the fuel cell system **20** or the battery system **30** associated with the one or more operational properties **P** of said fuel cell system **20** or battery system **30**. The step **920** may comprise determining the present operating region **O** of the fuel cell system **20** or the battery system **30** based on the operational data **D**. The step **930** may comprise estimating one or more energy storage properties **E** of the fuel cell system **20** or the battery system **30** based on the determined present operating region **O**. The step **940** may comprise controlling the power transfer to and/or from the fuel cell system **20** and the power transfer to and/or from battery system **30** based on the estimated one or more energy storage properties **E**.

FIG. 8 **is** a flow chart of the computer-implemented method **900** depicted in FIG. 7 according an example.

In the depicted example, the computer-implemented method **900** may further comprise a step **911** of obtaining the stack voltage **US** of the energy storage system **16**. The step **930** of estimating may further comprise estimating the one or more energy storage properties **E** of the energy storage system **16** based on the determined present operating region **O** and the stack voltage **US**.

In the depicted example, the computer-implemented method **900** may further comprise a step **931** of determining a measure of uncertainty for the estimated one or more energy storage properties **E**. The step **940** of controlling the power transfer to and/or from the energy storage system **16** may be based on the measure of uncertainty.

The steps **910, 911, 920, 930, 931, 940** of the method **900** may be carried out by processing circuitry of a computer system, such as the computer system **100** and processing circuitry **102**.

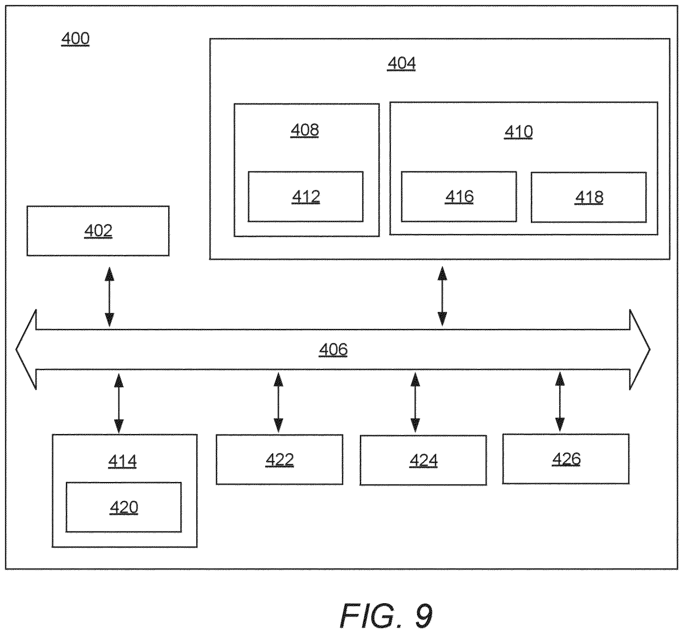

FIG. 9 is a schematic diagram of a computer system **400** for implementing examples disclosed herein. The computer system **400** is adapted to execute instructions from a computer-readable medium to perform these and/or any of the functions or processing described herein. The computer system **400** may be connected (e.g., networked) to other machines in a LAN (Local Area Network), LIN (Local Interconnect Network), automotive network communication protocol (e.g., FlexRay), an intranet, an extranet, or the Internet. While only a single device is illustrated, the computer system **400** may include any collection of devices that individually or jointly execute a set (or multiple sets) of instructions to perform any one or more of the methodologies discussed herein. Accordingly, any reference in the disclosure and/or claims to a computer system, computing system, computer device, computing device, control system, control unit, electronic control unit (ECU), processor device, processing circuitry, etc., includes reference to one or more such devices to individually or jointly execute a set (or multiple sets) of instructions to perform any one or more of the methodologies discussed herein. For example, control system may include a single control unit or a plurality of control units connected or otherwise communicatively coupled to each other, such that any performed function may be distributed between the control units as desired. Further, such devices may communicate with each other or other devices by various system architectures, such as directly or via a Controller Area Network (CAN) bus, etc.

The computer system **400** may comprise at least one computing device or electronic device capable of including firmware, hardware, and/or executing software instructions to implement the functionality described herein. The computer system **400** may include processing circuitry **402** (e.g., processing circuitry including one or more processor devices or control units), a memory **404,** and a system bus **406.** The computer system **400** may include at least one computing device having the processing circuitry **402**. The system bus **406** provides an interface for system components including, but not limited to, the memory **404** and the processing circuitry **402**. The processing circuitry **402** may include any number of hardware components for conducting data or signal processing or for executing computer code stored in memory **404.** The processing circuitry **402** may, for example, include a general-purpose processor, an application specific processor, a Digital Signal Processor (DSP), an Application Specific Integrated Circuit (ASIC), a Field Programmable Gate Array (FPGA), a circuit containing processing components, a group of distributed processing components, a group of distributed computers configured for processing, or other programmable logic device, discrete gate or transistor logic, discrete hardware components, or any combination thereof designed to perform the functions described herein. The processing circuitry **402** may further include computer executable code that controls operation of the programmable device.

The system bus **406** may be any of several types of bus structures that may further interconnect to a memory bus (with or without a memory controller), a peripheral bus, and/or a local bus using any of a variety of bus architectures. The memory **404** may be one or more devices for storing data and/or computer code for completing or facilitating methods described herein. The memory **404** may include database components, object code components, script components, or other types of information structure for supporting the various activities herein. Any distributed or local memory device may be utilized with the systems and methods of this description. The memory **404** may be communicably connected to the processing circuitry **402** (e.g., via a circuit or any other wired, wireless, or network connection) and may include computer code for executing one or more processes described herein. The memory **404** may include non-volatile memory **408** (e.g., read-only memory (ROM), erasable programmable read-only memory (EPROM), electrically erasable programmable read-only memory (EEPROM), etc.), and volatile memory **410** (e.g., random-access memory (RAM)), or any other medium which can be used to carry or store desired program code in the form of machine-executable instructions or data structures and which can be accessed by a computer or other machine with processing circuitry **402**. A basic input/output system (BIOS) **412** may be stored in the non-volatile memory **408** and can include the basic routines that help to transfer information between elements within the computer system **400**.

The computer system **400** may further include or be coupled to a non-transitory computer-readable storage medium such as the storage device **414**, which may comprise, for example, an internal or external hard disk drive (HDD) (e.g., enhanced integrated drive electronics (EIDE) or serial advanced technology attachment (SATA)), HDD (e.g., EIDE or SATA) for storage, flash memory, or the like. The storage device **414** and other drives associated with computer-readable media and computer-usable media may provide non-volatile storage of data, data structures, computer-executable instructions, and the like.

Computer-code which is hard or soft coded may be provided in the form of one or more modules. The module(s) can be implemented as software and/or hard-coded in circuitry to implement the functionality described herein in whole or in part. The modules may be stored in the storage device **414** and/or in the volatile memory **410**, which may include an operating system **416** and/or one or more program modules **418**. All or a portion of the examples disclosed herein may be implemented as a computer program **420** stored on a transitory or non-transitory computer-usable or computer-readable storage medium (e.g., single medium or multiple media), such as the storage device **414**, which includes complex programming instructions (e.g., complex computer-readable program code) to cause the processing circuitry **402** to carry out actions described herein. Thus, the computer-readable program code of the computer program **420** can comprise software instructions for implementing the functionality of the examples described herein when executed by the processing circuitry **402**. In some examples, the storage device **414** may be a computer program product (e.g., readable storage medium) storing the computer program **420** thereon, where at least a portion of a computer program **420** may be loadable (e.g., into a processor) for implementing the functionality of the examples described herein when executed by the processing circuitry **402**. The processing circuitry **402** may serve as a controller or control system for the computer system **400** that is to implement the functionality described herein.

The computer system **400** may include an input device interface **422** configured to receive input and selections to be communicated to the computer system **400** when executing instructions, such as from a keyboard, mouse, touch-sensitive surface, etc. Such input devices may be connected to the processing circuitry **402** through the input device interface **422** coupled to the system bus **406** but can be connected through other interfaces, such as a parallel port, an Institute of Electrical and Electronic Engineers (IEEE) 1394 serial port, a Universal Serial Bus (USB) port, an IR interface, and the like. The computer system **400** may include an output device interface **424** configured to forward output, such as to a display, a video display unit (e.g., a liquid crystal display (LCD) or a cathode ray tube (CRT)). The computer system **400** may include a communications interface **426** suitable for communicating with a network as appropriate or desired.

The operational actions described in any of the exemplary aspects herein are described to provide examples and discussion. The actions may be performed by hardware components, may be embodied in machine-executable instructions to cause a processor to perform the actions, or may be performed by a combination of hardware and software. Although a specific order of method actions may be shown or described, the order of the actions may differ. In addition, two or more actions may be performed concurrently or with partial concurrence.

In one aspect, a system, vehicle, method, computer program product and non-transitory computer-readable storage medium according to any of the following examples may be provided.

Example 1: Computer system (100; 400) comprising processing circuitry (102; 402) configured to: during use of an energy storage system (16) of a vehicle (10), obtain operational data (D) associated with one or more operational properties (P) of the present operation of the energy storage system (16), determine a present operating region (O) of the energy storage system (16) based on the operational data (D), estimate one or more energy storage properties (E) of the energy storage system (16) based on the determined present operating region (O), and control the power transfer to and/or from the energy storage system (16) based on the estimated one or more energy storage properties (E).

Example 2: Computer system (100; 400) of example 1, wherein the processing circuitry (102; 402) is further configured to: control the power transfer between the energy storage system (16) and a propulsion source (15) of the vehicle (10) based on the estimated one or more energy storage properties (E).

Example 3: The computer system (100; 400) of example 1 or 2, wherein the one or more operational properties (P) comprises a stack current (IS) of the energy storage system (16), a state of charge (SOC) of the energy storage system (16), a pressure (PE) in the energy storage system (16) and/or a stack temperature (T) of the energy storage system (16).

Example 4: The computer system (100; 400) of any of example 1-3, wherein the energy storage system (16) is a fuel cell system (20), and wherein the one or more energy storage properties (E) is one or more of a Nernst voltage, ohmic losses and/or activation losses of the fuel cell system (20).

Example 5: The computer system (100; 400) of any of example 1-3, wherein the energy storage system (16) is a battery system (30), and wherein the one or more energy storage properties (E) is one or more of an open-circuit voltage, ohmic losses and/or activation losses of the battery system (30).

Example 6: The computer system (100; 400) of any of example 1-5, wherein the processing circuitry (102; 402) is further configured to: determine the present operating region (O) as a subset of the total operating range of the energy storage system (16).

Example 7: The computer system (100; 400) of any of example 1-6, wherein the processing circuitry (102; 402) is further configured to: obtain a stack voltage (US) of the energy storage system (16), and estimate the one or more energy storage properties (E) of the energy storage system (16) based on the determined present operating region (O) and the stack voltage (US).

Example 8: The computer system (100; 400) of example 7, wherein the processing circuitry (102; 402) is further configured to: obtain a DC-DC output current and DC-DC output voltage of the energy storage system (16), and obtain the stack voltage (US) and stack current (IS) based on the DC-DC output current and DC-DC output voltage and a model of a DC-DC converter (90) of the vehicle (10) connected to the energy storage system (16).

Example 9: The computer system (100; 400) of example 8, wherein the processing circuitry (102; 402) is further configured to: obtain the stack voltage (US) and the stack current (IS) of the energy storage system (16) based on sensor data obtained from an electric voltage sensor (190A) and an electric current sensor (190B) configured to measure the energy storage voltage and energy storage current associated with the energy storage system (16), respectively.

Example 10: The computer system (100; 400) of any of example 1-9, wherein the processing circuitry (102; 402) is further configured to: determine a measure of uncertainty for the estimated one or more energy storage properties (E), and control the power transfer to and/or from the energy storage system (16) based on the measure of uncertainty.

Example 11: The computer system (100; 400) of any of claim 1-10, wherein the processing circuitry (102; 402) is further configured to estimate the one or more energy storage properties (E) for the determined present operating region (O) based on sliding window estimation or recursive estimation.

Example 12: The computer system (100; 400) of any of example 1-11, wherein the vehicle (10) comprises a first energy storage system provided as a fuel cell system (20) and a second energy storage system provided as a battery system (30), wherein the processing circuitry (102; 402) is further configured to: during use of the fuel cell system (20) or the battery system (30) obtain operational data (D) associated with one or more operational properties (P) of the present operation of said fuel cell system (20) or battery system (30), determine the present operating region (O) of the fuel cell system (20) or the battery system (30) based on the operational data (D), estimate one or more energy storage properties (E) of the fuel cell system (20) or battery system (30) based on the determined present operating region (O), and control the power transfer to and/or from the fuel cell system (20) or battery system (30) based on the estimated one or more energy storage properties (E).

Example 13: The computer system (100; 400) of example 1, wherein the one or more present operational properties (P) comprises a stack current (IS), a state of charge (SOC) of the energy storage system (16), a pressure (PE) in the energy storage system (16) and/or a stack temperature (T) of the energy storage system (16), wherein the processing circuitry (102; 402) is further configured to: determine the present operating region (O) as a subset of the total operating range of the energy storage system (16), obtain a stack voltage (US) of the energy storage system (16), obtain a DC-DC output current and DC-DC output voltage of the energy storage system (16), obtain the stack voltage (US) and stack current (IS) based on the DC-DC output current and DC-DC output voltage and a model of a DC-DC converter of the vehicle (10) connected to the energy storage system (16) and estimate the one or more energy storage properties (E) of the energy storage system (16) based on the determined present operating region (O) and the stack voltage (US), determine a measure of uncertainty for the estimated one or more energy storage properties (E), and control the power transfer to and/or from the energy storage system (16) based on the measure of uncertainty.

Example 14: A vehicle (10) comprising the computer system (100; 400) of any of examples 1-13.

Example 15: The vehicle (10) of example 14, further comprising: a fuel cell system (20) comprising a fuel cell stack (22), and a battery system (30) comprising a vehicle battery (32).

Example 16: A computer-implemented method (900) comprising: during use of an energy storage system (16) of a vehicle (10), obtaining (910), by processing circuitry (102; 402) of a computer system (400), operational data (D) associated with one or more operational properties (P) of the present operation of the energy storage system (16), determining (920), by the processing circuitry (102; 402), a present operating region (O) of the energy storage system (16) based on the operational data (D), estimating (930), by the processing circuitry (102; 402), one or more energy storage properties (E) of the energy storage system (16) based on the present operating region (O), and controlling (940), by the processing circuitry (102; 402), the power transfer to and/or from the energy storage system (16) based on the estimated one or more energy storage properties (E).

Example 17: The computer-implemented method (900) of example 16, further comprising: obtaining (911), by the processing circuitry (102; 402), a stack voltage (US) of the energy storage system (16), and estimating (930), by the processing circuitry (102; 402), the one or more energy storage properties (E) of the energy storage system (16) based on the determined present operating region (O) and the stack voltage (US).

Example 18: The computer-implemented method (900) of example 16 or 17 further comprising: determining (931), by the processing circuitry (102; 402), a measure of uncertainty for the estimated one or more energy storage properties (E), and controlling (940), by the processing circuitry (102; 402), the power transfer to and/or from the energy storage system (16) based on the measure of uncertainty.

Example 19: The computer-implemented method (900) of any of example 16-18, wherein the vehicle (10) comprises a first energy storage system provided as a fuel cell system (20) and a second energy storage system provided as a battery system (30), further comprising: during use of the fuel cell system (20) or the battery system (30), obtaining (910), by the processing circuitry (102; 402), operational data (D) associated with one or more operational properties (P) of the present operation of said fuel cell system (20) or battery system (30), determining (920), by the processing circuitry (102; 402), the present operating region (O) of the fuel cell system (20) or the battery system (30) based on the operational data (D), estimating (930), by the processing circuitry (102; 402), one or more energy storage properties (E) of the fuel cell system (20) or battery system (30) based on the determined present operating region (O), and controlling (940), by the processing circuitry (102;402), the power transfer to and/or from the fuel cell system (20) and the power transfer to and/or from the battery system (30) based on the estimated one or more energy storage properties (E).

Example 20: A computer program product comprising program code for performing, when executed by the processing circuitry, the computer-implemented method (900) of any of examples 15-18.

Example 21: A non-transitory computer-readable storage medium comprising instructions, which when executed by the processing circuitry, cause the processing circuitry to perform the computer-implemented method (900) of any of examples 15-18.

The terminology used herein is for the purpose of describing particular aspects only and is not intended to be limiting of the disclosure. As used herein, the singular forms "a," "an," and "the" are intended to include the plural forms as well, unless the context clearly indicates otherwise. As used herein, the term "and/or" includes any and all combinations of one or more of the associated listed items. It will be further understood that the terms "comprises," "comprising," "includes," and/or "including" when used herein specify the presence of stated features, integers, actions, steps, operations, elements, and/or components, but do not preclude the presence or addition of one or more other features, integers, actions, steps, operations, elements, components, and/or groups thereof.

It will be understood that, although the terms first, second, etc., may be used herein to describe various elements, these elements should not be limited by these terms. These terms are only used to distinguish one element from another. For example, a first element could be termed a second element, and, similarly, a second element could be termed a first element without departing from the scope of the present disclosure.

Relative terms such as "below" or "above" or "upper" or "lower" or "horizontal" or "vertical" may be used herein to describe a relationship of one element to another element as illustrated in the Figures. It will be understood that these terms and those discussed above are intended to encompass different orientations of the device in addition to the orientation depicted in the Figures. It will be understood that when an element is referred to as being "connected" or "coupled" to another element, it can be directly connected or coupled to the other element, or intervening elements may be present. In contrast, when an element is referred to as being "directly connected" or "directly coupled" to another element, there are no intervening elements present.

Unless otherwise defined, all terms (including technical and scientific terms) used herein have the same meaning as commonly understood by one of ordinary skill in the art to which this disclosure belongs. It will be further understood that terms used herein should be interpreted as having a meaning consistent with their meaning in the context of this specification and the relevant art and will not be interpreted in an idealized or overly formal sense unless expressly so defined herein.

It is to be understood that the present disclosure is not limited to the aspects described above and illustrated in the drawings; rather, the skilled person will recognize that many changes and modifications may be made within the scope of the present disclosure and appended claims. In the drawings and specification, there have been disclosed aspects for purposes of illustration only and not for purposes of limitation, the scope of the disclosure being set forth in the following claims.

**Claims**

1. Computer system (100; 400) comprising processing circuitry (102; 402) configured to:

    during use of an energy storage system (16) of a vehicle (10), obtain operational data (D) associated with one or more operational properties (P) of the present operation of the energy storage system (16),
    determine a present operating region (O) of the energy storage system (16) based on the operational data (D),
    estimate one or more energy storage properties (E) of the energy storage system (16) based on the determined present operating region (O), and
control the power transfer to and/or from the energy storage system (16) based on the estimated one or more energy storage properties (E).

2. Computer system (100; 400) of claim 1, wherein the processing circuitry (102; 402) is further configured to:
control the power transfer between the energy storage system (16) and a propulsion source (15) of the vehicle (10) based on the estimated one or more energy storage properties (E).

3. The computer system (100; 400) of claim 1 or 2, wherein the one or more operational properties (P) comprises a stack current (IS) of the energy storage system (16), a state of charge (SOC) of the energy storage system (16), a pressure (PE) in the energy storage system (16) and/or a stack temperature (T) of the energy storage system (16).

4. The computer system (100; 400) of any of claim 1-3, wherein the energy storage system (16) is a fuel cell system (20), and wherein the one or more energy storage properties (E) is one or more of a Nernst voltage, ohmic losses and/or activation losses of the fuel cell system (20).

5. The computer system (100; 400) of any of claim 1-3, wherein the energy storage system (16) is a battery system (30), and wherein the one or more energy storage properties (E) is one or more of an open-circuit voltage, ohmic losses and/or activation losses of the battery system (30).

6. The computer system (100; 400) of any of claim 1-5, wherein the processing circuitry (102; 402) is further configured to: determine the present operating region (O) as a subset of the total operating range of the energy storage system (16).

7. The computer system (100; 400) of any of claim 1-6, wherein the processing circuitry (102; 402) is further configured to:

obtain a stack voltage (US) of the energy storage system (16), and
estimate the one or more energy storage properties (E) of the energy storage system (16) based on the determined present operating region (O) and the stack voltage (US).

8. The computer system (100; 400) of any of claim 1-7, wherein the processing circuitry (102; 402) is further configured to:

determine a measure of uncertainty for the estimated one or more energy storage properties (E), and
control the power transfer to and/or from the energy storage system (16) based on the measure of uncertainty.

9. The computer system (100; 400) of any of claim 1-8, wherein the processing circuitry (102; 402) is further configured to estimate the one or more energy storage properties (E) for the determined present operating region (O) based on sliding window estimation or recursive estimation.

10. The computer system (100; 400) of any of claim 1-9, wherein the vehicle (10) comprises a first energy storage system provided as a fuel cell system (20) and a second energy storage system provided as a battery system (30), wherein the processing circuitry (102; 402) is further configured to:

during use of the fuel cell system (20) or the battery system (30) obtain operational data (D) associated with one or more operational properties (P) of the present operation of said fuel cell system (20) or battery system (30),
determine the present operating region (O) of the fuel cell system (20) or the battery system (30) based on the operational data (D),
estimate one or more energy storage properties (E) of the fuel cell system (20) or battery system (30) based on the determined present operating region (O), and
control the power transfer to and/or from the fuel cell system (20) or battery system (30) based on the estimated one or more energy storage properties (E).

11. The computer system (100; 400) of claim 1, wherein the one or more present operational properties (P) comprises a stack current (IS), a state of charge (SOC) of the energy storage system (16), a pressure (PE) in the energy storage system (16) and/or a stack temperature (T) of the energy storage system (16),
wherein the processing circuitry (102; 402) is further configured to:

determine the present operating region (O) as a subset of the total operating range of the energy storage system (16),

obtain a stack voltage (US) of the energy storage system (16),

obtain a DC-DC output current and DC-DC output voltage of the energy storage system (16),

obtain the stack voltage (US) and stack current (IS) based on the DC-DC output current and DC-DC output voltage and a model of a DC-DC converter of the vehicle (10) connected to the energy storage system (16) and estimate the one or more energy storage properties (E) of the energy storage system (16) based on the determined present operating region (O) and the stack voltage (US),

determine a measure of uncertainty for the estimated one or more energy storage properties (E), and

control the power transfer to and/or from the energy storage system (16) based on the measure of uncertainty.

12. A vehicle (10) comprising the computer system (100; 400) of any of claims 1-11.

13. A computer-implemented method (900) comprising:

during use of an energy storage system (16) of a vehicle (10), obtaining (910), by processing circuitry (102; 402) of a computer system (400), operational data (D) associated with one or more operational properties (P) of the present operation of the energy storage system (16),

determining (920), by the processing circuitry (102; 402), a present operating region (O) of the energy storage system (16) based on the operational data (D),

estimating (930), by the processing circuitry (102; 402), one or more energy storage properties (E) of the energy storage system (16) based on the present operating region (O), and

controlling (940), by the processing circuitry (102; 402), the power transfer to and/or from the energy storage system (16) based on the estimated one or more energy storage properties (E).

14. A computer program product comprising program code for performing, when executed by the processing circuitry, the computer-implemented method (900) of claim 13.

15. A non-transitory computer-readable storage medium comprising instructions, which when executed by the processing circuitry, cause the processing circuitry to perform the computer-implemented method (900) of claim 13.

**Amended claims in accordance with Rule 137(2) EPC.**

1. Computer system (100; 400) comprising processing circuitry (102; 402) configured to:

during use of an energy storage system (16) of a vehicle (10), obtain operational data (D) associated with one or more operational properties (P) of the present operation of the energy storage system (16),

determine a present operating region (O) of the energy storage system (16) as a subset of the total operating range of said energy storage system (16) based on the operational data (D),

estimate one or more energy storage properties (E) of the energy storage system (16) based on the determined present operating region (O), and

control the power transfer to and/or from the energy storage system (16) and a propulsion source (15) of the vehicle (10) based on the estimated one or more energy storage properties (E) and control the power transfer between the energy storage system (16) and a propulsion source (15) of the vehicle (10) based on said estimated one or more energy storage properties (E).

2. The computer system (100; 400) of claim 1, wherein the one or more operational properties (P) comprises a stack current (IS) of the energy storage system (16), a state of charge (SOC) of the energy storage system (16), a pressure (PE) in the energy storage system (16) and/or a stack temperature (T) of the energy storage system (16).

3. The computer system (100; 400) of any of claim 1-2, wherein the energy storage system (16) is a fuel cell system (20), and wherein the one or more energy storage properties (E) is one or more of a Nernst voltage, ohmic losses and/or activation losses of the fuel cell system (20).

4. The computer system (100; 400) of any of claim 1-2, wherein the energy storage system (16) is a battery system (30), and wherein the one or more energy storage properties (E) is one or more of an open-circuit voltage, ohmic losses and/or activation losses of the battery system (30).

5. The computer system (100; 400) of any of claim 1-4, wherein the processing circuitry (102; 402) is further configured to:

   obtain a stack voltage (US) of the energy storage system (16), and
   estimate the one or more energy storage properties (E) of the energy storage system (16) based on the determined present operating region (O) and the stack voltage (US).

6. The computer system (100; 400) of any of claim 1-5, wherein the processing circuitry (102; 402) is further configured to:

   determine a measure of uncertainty for the estimated one or more energy storage properties (E), and
   control the power transfer to and/or from the energy storage system (16) based on the measure of uncertainty.

7. The computer system (100; 400) of any of claim 1-6, wherein the processing circuitry (102; 402) is further configured to estimate the one or more energy storage properties (E) for the determined present operating region (O) based on sliding window estimation or recursive estimation.

8. The computer system (100; 400) of any of claim 1-7, wherein the vehicle (10) comprises a first energy storage system provided as a fuel cell system (20) and a second energy storage system provided as a battery system (30), wherein the processing circuitry (102; 402) is further configured to:

   during use of the fuel cell system (20) or the battery system (30) obtain operational data (D) associated with one or more operational properties (P) of the present operation of said fuel cell system (20) or battery system (30),
   determine the present operating region (O) of the fuel cell system (20) or the battery system (30) based on the operational data (D),
   estimate one or more energy storage properties (E) of the fuel cell system (20) or battery system (30) based on the determined present operating region (O), and
   control the power transfer to and/or from the fuel cell system (20) or battery system (30) based on the estimated one or more energy storage properties (E).

9. The computer system (100; 400) of claim 1, wherein the one or more present operational properties (P) comprises a stack current (IS), a state of charge (SOC) of the energy storage system (16), a pressure (PE) in the energy storage system (16) and/or a stack temperature (T) of the energy storage system (16),
   wherein the processing circuitry (102; 402) is further configured to:

   determine the present operating region (O) as a subset of the total operating range of the energy storage system (16),
   obtain a stack voltage (US) of the energy storage system (16),
   obtain a DC-DC output current and DC-DC output voltage of the energy storage system (16),
   obtain the stack voltage (US) and stack current (IS) based on the DC-DC output current and DC-DC output voltage and a model of a DC-DC converter of the vehicle (10) connected to the energy storage system (16) and estimate the one or more energy storage properties (E) of the energy storage system (16) based on the determined present operating region (O) and the stack voltage (US),
   determine a measure of uncertainty for the estimated one or more energy storage properties (E), and
   control the power transfer to and/or from the energy storage system (16) based on the measure of uncertainty.

10. A vehicle (10) comprising the computer system (100; 400) of any of claims 1-9.

11. A computer-implemented method (900) comprising:

    during use of an energy storage system (16) of a vehicle (10), obtaining (910), by processing circuitry (102; 402) of a computer system (400), operational data (D) associated with one or more operational properties (P) of the present operation of the energy storage system (16),
    determining (920), by the processing circuitry (102; 402), a present operating region (O) of the energy storage system (16) as a subset of the total operating range of said energy storage system (16) based on the operational data (D),
    estimating (930), by the processing circuitry (102; 402), one or more energy storage properties (E) of the energy storage system (16) based on the present operating region (O),

controlling (940), by the processing circuitry (102; 402), the power transfer to and/or from the energy storage system (16) based on the estimated one or more energy storage properties (E), and
controlling, by the processing circuitry (102; 402) the power transfer between the energy storage system (16) and a propulsion source (15) of the vehicle (10) based on said estimated one or more energy storage properties (E).

12. A computer program product comprising program code for performing, when executed by the processing circuitry, the computer-implemented method (900) of claim 11.

13. A non-transitory computer-readable storage medium comprising instructions, which when executed by the processing circuitry, cause the processing circuitry to perform the computer-implemented method (900) of claim 11.

*FIG. 1*

**100** Computer system

**102** Processing circuitry

**D** Operational data

**IS** Stack current

**SOC** State of charge

**PE** pressure

**T** stack temperature

**ED** Energy storage data

**US** Stack voltage

**190** Sensor circuitry

**190A** Voltage sensor

**190B** Current sensor

**190C** State of charge sensor

**190D** Temperature sensor

**190E** Pressure sensor

**16** Energy storage system

*FIG. 2*

**140** Non-volatile memory

**106** Model

**100** Computer system

**102** Processing circuitry

**D** Operational data

**IS** Stack current

**ED** Energy storage data

**US** Stack voltage

**190** Sensor circuitry

**190A** Voltage sensor

**190B** Current sensor

**90** DC-DC converter

**16** Energy storage system

*FIG. 3*

**100** Computer system

**102** Processing circuitry

**D20** Operational data

**D30** Operational data

**20** Fuel cell system

**22** Fuel cell stack

**30** Battery system

**32** Vehicle battery

**15** Propulsion source

*FIG. 4*

FIG. 5

**100** Computer system

**150** Energy storage property estimator

**151** Sliding window modulator

**152** Recursive modulator

Energy storage property **E**

## FIG. 6A

Assess operational data **D**

Define operating region **O** for estimation

Adapt length of memory used for estimation

Estimate one or more energy storage property **E**

Update Energy storage properties **E** for operating region **O**

Include uncertainty of estimated energy storage property **E**

## FIG. 6B

*FIG. 6C*

900

| 910 |
| :-: |
| Obtaining operational data **D** associated with operational property **P** |

| 920 |
| :-: |
| Determining present operating region **O** |

| 930 |
| :-: |
| Estimating energy storage property **E** |

| 940 |
| :-: |
| Controlling power transfer |

*FIG. 7*

900

| 911 |
| :-: |
| Obtaining stack voltage **US** |

| 931 |
| :-: |
| Determining measure of uncertainty |

| 910 |
| :-: |
| Obtaining operational data **D** associated with operational property **P** |

| 920 |
| :-: |
| Determining present operating region **O** |

| 930 |
| :-: |
| Estimating energy storage property **E** |

| 940 |
| :-: |
| Controlling power transfer |

*FIG. 8*

FIG. 9

Europäisches
Patentamt
European
Patent Office
Office européen
des brevets

# EUROPEAN SEARCH REPORT

**Application Number**

EP 24 19 4073

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2008/076012 A1 (LIENKAMP SEBASTIAN [DE] ET AL) 27 March 2008 (2008-03-27) * figures 1,3 * * paragraphs [0015], [0029], [0024], [0009], [0030], [0034], [0014] * ----- | 1-15 | INV. B60L3/12 B60L50/75 B60L58/40 B60L58/30 |
| A | US 2024/157850 A1 (KUMARASWAMY ANIROODH [IN] ET AL) 16 May 2024 (2024-05-16) * paragraphs [0009], [0098], [0110] * ----- | 1-15 | |

**TECHNICAL FIELDS SEARCHED (IPC)**

B60L

The present search report has been drawn up for all claims

| Place of search | Date of completion of the search | Examiner |
|---|---|---|
| The Hague | 3 February 2025 | Herrera Caballero, A |

CATEGORY OF CITED DOCUMENTS

X : particularly relevant if taken alone
Y : particularly relevant if combined with another
    document of the same category
A : technological background
O : non-written disclosure
P : intermediate document

T : theory or principle underlying the invention
E : earlier patent document, but published on, or
    after the filing date
D : document cited in the application
L : document cited for other reasons

................................................................................

& : member of the same patent family, corresponding
    document

EPO FORM 1503 03.82 (P04C01)

## ANNEX TO THE EUROPEAN SEARCH REPORT
## ON EUROPEAN PATENT APPLICATION NO.

EP 24 19 4073

This annex lists the patent family members relating to the patent documents cited in the above-mentioned European search report.
The members are as contained in the European Patent Office EDP file on
The European Patent Office is in no way liable for these particulars which are merely given for the purpose of information.

03-02-2025

| Patent document cited in search report | Publication date | Patent family member(s) | | Publication date |
|---|---|---|---|---|
| US 2008076012 A1 | 27-03-2008 | DE 102007044640 A1 | | 17-04-2008 |
| | | US 2008076012 A1 | | 27-03-2008 |
| | | US 2010092817 A1 | | 15-04-2010 |
| US 2024157850 A1 | 16-05-2024 | CN 118003984 A | | 10-05-2024 |
| | | EP 4368446 A1 | | 15-05-2024 |
| | | US 2024157850 A1 | | 16-05-2024 |

EPO FORM P0459

For more details about this annex : see Official Journal of the European Patent Office, No. 12/82